# EUROPEAN PATENT SPECIFICATION

(11) **EP 2 594 947 B1**
(45) Date of publication and mention of the grant of the patent: **30.06.2021**
(21) Application number: 11806779.2
(22) Date of filing: 12.07.2011
(51) Int. Cl.: G01R 31/3835, G01R 31/396

(54) **BATTERY PACK VOLTAGE DETECTION DEVICE**
VORRICHTUNG ZUR ERKENNUNG DER SPANNUNG EINES BATTERIEPACKS
DISPOSITIF DE DÉTECTION DE TENSION DE BLOC-PILES

(30) Priority: 14.07.2010 JP 2010159443
(43) Date of publication of application: 22.05.2013
(73) Proprietor: Yazaki Corporation, Minto-ku Tokyo 108-0073 (JP)
(72) Inventor: IZAWA, Takaaki, Susono-shi, Shizuoka 410-1107 (JP)
(74) Representative: Hoffmann Eitle
(86) International application number: PCT/JP2011/065889
(87) International publication number: WO 2012/008449

(56) References cited:
- JP-A- 2003 114 266
- JP-A- 2006 064 639
- JP-A- 2009 183 025
- US-A1- 2007 024 270
- US-A1- 2009 128 158
- US-A1- 2010 134 132

## Description

### Technical Field

The present invention relates to, in a battery pack which includes a plurality of unit cells connected in series and outputs a predetermined voltage, a voltage detection device detecting whether output voltage of each unit cell is conformity. More specifically, the present invention relates to a technique to diagnose whether various types of devices concerning voltage measurement are operating in conformity.

### Background Art

For example, a secondary battery mounted on a hybrid vehicle or an electric vehicle includes a plurality of unit cells connected in series, each of the unit cells outputting a predetermined voltage. The secondary battery generates a high voltage of 200 V, for example, across the both ends of the series-connected circuit and uses the generated electric power to drive a driving motor. In such a battery pack including a plurality of unit cells connected in series, each of the unit cells sometimes deteriorates over time. In order to quickly detect and repair a deteriorated battery, conventional battery packs are provided with voltage detection devices to detect whether the charge voltage of each unit cell is conformity.

One of such conventional voltage detection devices is described in PTL 1. In the disclosure of PTL 1, an analogue reference voltage, which is constant, is digitized by an A/D converter, and the digitized voltage data is compared with reference data. If the digitized voltage data matches the reference data, it is determined that the A/D converter is conformity, and otherwise, it is determined that the A/D converter is nonconformity.

### Citation List

### Patent Literature

PTL 1: JP 2010-58244 A

Patent document US 2010/134132 A1 relates to a voltage monitoring circuit having a self-test function. More specifically, multiple window comparators used to measure the voltages of a battery pack are discussed. Each comparator is provided with a self-test function. The self-test function is achieved by applying one of two test voltages to the comparators, either simulating an over-range fault or an under-range fault.

Patent document US 2009/128158 A1 relates to a voltage detection device for detecting voltage of a battery pack of an electric vehicle. Specifically, a voltage detection device for accurately correcting detection errors in voltages greater than or equal to an internal reference voltage is discussed. A detection error of a voltage detector is corrected using a discharge voltage of a capacitor as a reference.

### Summary of Invention

The voltage detection device described in PTL 1 can detect nonconformity of the A/D converter measuring voltages of the plurality of battery cells constituting a battery pack (digitizing analogue voltage signals) but cannot detect nonconformity which occurs in various types of measurement equipment provided between the battery cells and the A/D converter.

The present invention is set out in the appended set of claims and was made to solve the aforementioned conventional problem, and an object of the present invention is to provide a battery pack voltage detection device which is capable of detecting nonconformity of a device measuring voltage of a battery block with high accuracy.

A solution of at least parts of the above problems is achieved by the independent claim 1 In order to achieve the aforementioned object, a voltage detection device according to a first aspect is provided for a battery pack which includes a series circuit having two or more battery blocks connected in series and generates a desired voltage across both ends of the series circuit and detects output voltage of each of the battery blocks, each of the battery blocks including one or more unit cells. The voltage detection device includes: a voltage selector which is connected to positive electrode terminals of the battery blocks through connection lines and selects output voltage of each of the battery blocks based on the voltages generated at the positive electrode terminals; first switches provided between the positive electrode terminals and the connection lines, respectively; an A/D converter for digitizing a signal of the output voltage selected by the voltage selector; a reference voltage output unit capable of supplying different levels of reference voltages to the respective connection lines; a second switch for switching between supply and cutoff of the reference voltages outputted from the reference voltage output unit to the respective connection lines; a controller performing a control to turn on the first switches and turn off the second switch in a process of detecting the output voltages of the battery blocks and to turn off the first switches and turn on the second switch in a process of fault diagnosis for the voltage selector and the A/D converter; and a fault detector which determines based on a voltage signal outputted from the A/D converter whether at least one of the voltage selector and A/D converter is failing.

In the voltage detection device according to the first aspect of the present invention, preferably, the reference voltage output unit includes series-connected circuits each having two resistors corresponding to each of the connection lines, an intermediate point between the two resistors of each of the series-connected circuits is connected to concerned connection line, one end of each of the series-connected circuits is connected to a DC power supply, and voltage supplied to the concerned connection line is set by setting proper resistive values of the two resistors of each of the series-connected circuits.

In the above case, preferably, the series-connected circuits are connected to a common DC power supply.

In the voltage detection device according the first aspect, each of the battery blocks may be composed of one unit cell.

In the voltage detection device according to the first aspect, the battery pack may be a secondary battery mounted on a vehicle.

With the voltage detection device according to the first aspect, in the process of diagnosing the voltage selector and the A/D converter, the reference voltages having predetermined voltage values are applied to the connection lines and digitized by the A/D converter, and based on the digitized voltage signals, the voltage selector and A/D converter are diagnosed. Accordingly, it is possible to detect nonconformity of entire measurement equipment concerning measurement of voltage and implement quick and highly accurate nonconformity detection.

### Brief Description of Drawings

[Fig. 1]
Fig. 1 is a circuit diagram illustrating a configuration of a battery pack voltage detection device according to a first embodiment.
[Fig. 2] Fig. 2 is a flowchart illustrating a processing operation of the battery pack voltage detection device according to the first embodiment.
[Fig. 3] Fig. 3 is a circuit diagram illustrating a configuration of a battery pack voltage detection device according to a modification of the first embodiment.

### Description of Embodiments

Hereinafter, a description is given of embodiments with reference to the drawings.

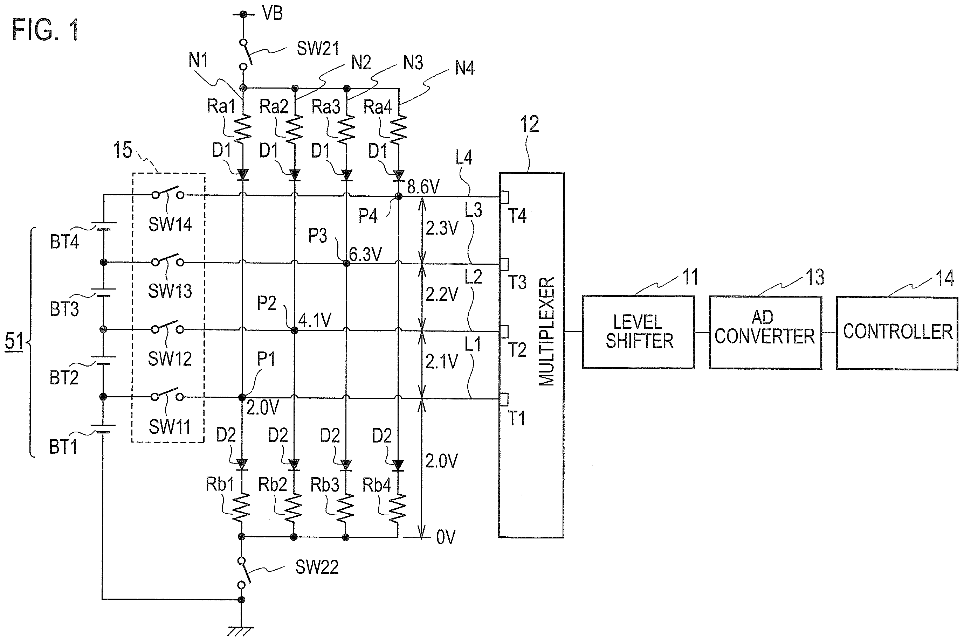

Fig. 1 is a block diagram illustrating a configuration of a battery pack voltage detection device according to a first embodiment and the battery pack connected to the voltage detection device. As illustrated in Fig. 1, a battery pack 51 is used as a secondary battery provided for an electric vehicle, for example, and includes four unit cells BT1 to BT4 (for example, lithium-ion cells) which are connected in series. In the first embodiment, for ease of explanation, the four unit cells BT1 to BT4 are illustrated, but the number of unit cells may be one, two, three, five, or more.

The voltage detection device illustrated in Fig. 1 includes: a multiplexer (voltage selector) 12 for selecting output voltage of each of the unit cells BT1 to BT4; a level shifter 11 for level-shifting the voltage signal selected by the multiplexer 12; an A/D converter 13 for digitizing the level-shifted voltage signal; and a controller 14 provided downstream of the A/D converter 13.

The controller 14 determines based on the voltage signal outputted from the A/D converter 13 whether the measured voltage is nonconformity. If determining that the measured voltage is nonconformity, the controller 14 outputs an alarm signal to an alarm device (not illustrated) or the like which are provided downstream. Moreover, in the process of diagnosing the operations of the multiplexer 12 and the A/D converter 13, the controller 14 outputs switching signals to later-described switches SW11 to SW14 (first switches) and switches 21 and 22 (second switches).

In other words, the controller 14 includes a function as a fault detector which determines at a fault diagnosis based on the voltage signal outputted from the A/D converter 13 whether at least one of the multiplexer 12 and the A/D converter 13 is failing. Moreover, the controller 14 includes a function as a switching controller which performs a control to turn on the first switches (SW11 to SW14) and turn off the second switches (SW21, SW22) in the process of detecting the output voltage of each of battery blocks (each of the unit cells BT1 to BT4) and to turn off the first switches and turn on the second switches at the fault diagnosis for the multiplexer 12 and the A/D converter 13.

On the other hand, positive electrodes of the unit cells BT1 to BT4 constituting the battery pack 51 are connected to terminals T1 to T4 of the multiplexer 12 through a first switch group 15 and the connection lines L1 to L4, respectively. The first switch group 15 is composed of the switches SW11 to SW14. To be specific, the positive electrode of the unit cell BT1 is connected to one end of the connection line L1 through the switch SW11, and the other end of the connection line L1 is connected to the terminal T1 of the multiplexer 12. The positive electrode of the unit cell BT2 is connected to one end of the connection line L2 through the switch SW12, and the other end of the connection line L2 is connected to the terminal T2 of the multiplexer 12. The positive electrode of the unit cell BT3 is connected to one end of the connection line L3 through the switch SW13, and the other end of the connection line L3 is connected to the terminal T3 of the multiplexer 12. The positive electrode of the unit cell BT4 is connected to one end of the connection line L4 through the switch SW14, and the other end of the connection line L4 is connected to the terminal T4 of the multiplexer 12.

Furthermore, the voltage detection device illustrated in Fig. 1 includes the switch SW21 connected to a DC power supply VB and the switch SW22 connected to the ground. Between the switch SW21 and the switch SW22, four routes of series-connected circuits (first to fourth series-connected circuits N1 to N4; a reference voltage output unit) are provided.

The first series-connected circuit N1 includes a resistor Ra1, diodes D1 and D2, and a resistor Rb1, which are connected in series. The second series-connected circuit N2 includes a resistor Ra2, diodes D1 and D2, and a resistor Rb2, which are connected in series. The third series-connected circuit N3 includes a resistor Ra3, diodes D1 and D2, and a resistor Rb3, which are connected in series. The fourth series-connected circuit N4 includes a resistor Ra4, diodes D1 and D2, and a resistor Rb4, which are connected in series.

The first series-connected circuit N1 is connected to the connection line L1 at a point P1 between the diodes D1 and D2. When the switches SW21 and SW22 are both on, voltage obtained by dividing the voltage of the DC power supply VB by the resistors Ra1 and Rb1 is therefore applied to the point P1. Herein, voltage drops of the diodes d1 and d2 are ignored.

The second series-connected circuit N2 is connected to the connection line L2 at a point P2 between the diodes D1 and D2. When the switches SW21 and SW22 are both on, voltage obtained by dividing the voltage of the DC power supply VB by the resistors Ra2 and Rb2 is therefore applied to the point P2.

The third series-connected circuit N3 is connected to the connection line L3 at a point P3 between the diodes D1 and D2. When the switches SW21 and SW22 are both on, voltage obtained by dividing the voltage of the DC power supply VB by the resistors Ra3 and Rb3 is therefore applied to the point P3.

The fourth series-connected circuit N4 is connected to the connection line L4 at a point P4 between the diodes D1 and D2. When the switches SW21 and SW22 are both on, voltage obtained by dividing the voltage of the DC power supply VB by the resistors Ra4 and Rb4 is therefore applied to the point P4.

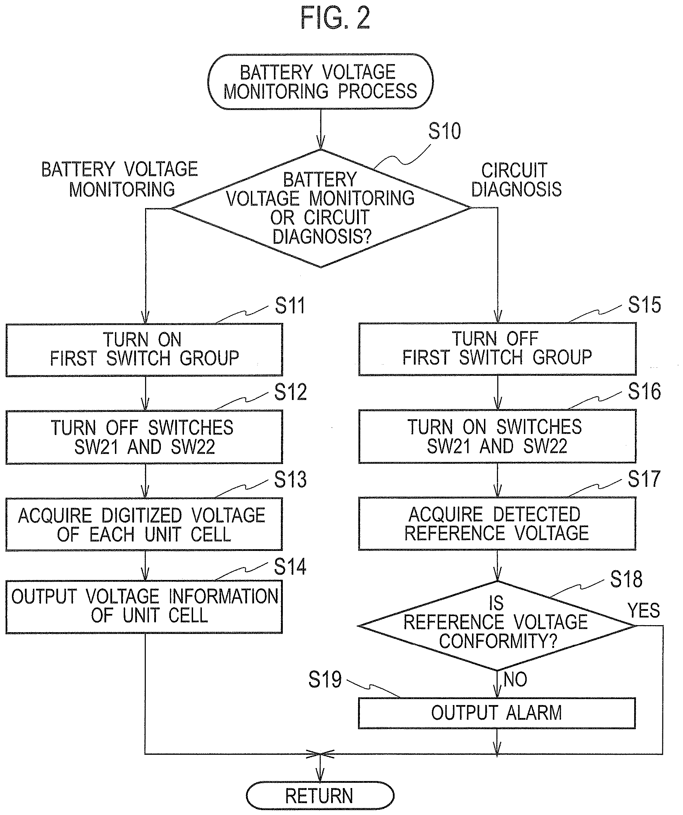

Next, a description is given of a process operation of the voltage detection device according to the first embodiment configured as described above with reference to the flowchart illustrated in Fig. 2. This process is executed under the control of the controller 14.

First, the controller 14 determines whether to execute the process of monitoring the voltages of the unit cells BT1 to BT4 or to execute the process of diagnosing the voltage measurement equipment (various devices from the multiplexer 12 to the A/D converter 13) (Step S10).

In the case of executing the process of monitoring the voltages of the unit cells BT1 to BT4 ("battery voltage monitoring" in the step S10), the controller 14 turns on all the switches of the first switch group 15 (step S11). Next, the controller 14 turns off the switches SW21 and SW22 (step S12).

The switches SW11 to SW14 illustrated in Fig. 1 are then turned on, and the voltages generated at the positive electrodes of the unit cells BT1 to BT4 are supplied to the terminals T1 to T4 of the multiplexer 12 through the connection lines L1 to L4, respectively. For example, the terminal T1 is supplied with a voltage of 2.0 V as the voltage of the positive electrode of the unit cell BT1. The terminal T2 is supplied with a voltage of 4.1 V as the voltage of the positive electrode of the unit cell BT2. The terminal T3 is supplied with a voltage of 6.3 V as the voltage of the positive electrode of the unit cell BT3. The terminal T4 is supplied with a voltage of 8.6 V as the voltage of the positive electrode of the unit cell BT4.

Moreover, for the switches SW21 and SW22 are both turned off, the output voltage from the DC power supply VB is not supplied. Moreover, for each of the series-connected circuits N1 to N4 includes the diodes D1 and D2, the connection lines L1 to L4 are not short-circuited via the series-connected circuits N1 to N4.

The analog voltage signal selected by the multiplexer 12 is supplied through the level shifter 11 to the A/D converter 13. The A/D converter 13 is capable of measuring the output voltages of the unit cells BT1 to BT4 based on the voltages supplied to the terminals T1 to T4. To be specific, the output voltages of the unit cells BT1 to BT4 are 2.0 V, 2.1 V (= 4.1 - 2.0), 2.2 V (= 6.3 - 4.1), and 2.3 V (= 8.6 - 6.3), respectively.

The measurement results of the unit cells BT1 to BT4 which are digitized by the A/D converter 13 are outputted to the controller 14 (step S13).

The controller 14 outputs the detected voltage information of the unit cells BT1 to BT4 to a display unit, an alarm unit, and the like (not illustrated) which are provided downstream (step S14). In this manner, the operator can recognize the output voltages of the unit cells BT1 to BT4 and can cope with nonconformity of the output voltages.

On the other hand, the circuit diagnosis process of the voltage detection device is executed when the power supply is turned on or each predetermined period of time, for example. In this case, the "circuit diagnosis" is selected in the step S10.

If the circuit diagnosis is selected, the controller 14 turns off all the switches of the first switch group 15 (step S15). The controller 14 then turns on both the switches SW21 and SW22 (step S16).

Accordingly, to the point P1, the voltage obtained by dividing the output voltage of the DC power supply VB by the resistors Ra1 and Rb1 is applied. In a similar manner, to the point P2, the voltage obtained by dividing the output voltage of the DC power supply VB by the resistors Ra2 and Rb2 is applied. To the point P3, the voltage obtained by dividing the output voltage of the DC power supply VB by the resistors Ra3 and Rb3 is applied. To the point P4, the voltage obtained by dividing the output voltage of the DC power supply VB by the resistors Ra4 and Rb4 is applied.

In this event, by properly setting the magnitudes of the resistors Ra1 to Ra4 and the resistors Rb1 to Rb4, the values of voltages generated at the points P1 to P4 can be set to desired values. For example, a voltage of 2V can be generated at the point P1; a voltage of 4V can be generated at the point P2; a voltage of 6V can be generated at the point P3; and a voltage of 8V can be generated at the point P4. These voltages are generated by dividing the voltage outputted from the DC power supply VB and, accordingly, can be generated with extremely high accuracy.

The voltages generated at the points P1 to P4 are supplied to the terminals T1 to T4 of the multiplexer 12, respectively. The multiplexer 12 selects the voltage between each pair of adjacent points (between P1 and the ground, P2 and P1, P3 and P2, and P4 and P3), shifts the level thereof, and then outputs the same to the A/D converter 13 for digitization of the voltage signal. The digitized voltage signal is acquired by the controller 14 (step S17).

The controller 14 determines whether the acquired reference voltage is conformity (step S18). If the acquired reference voltage is conformity (YES in the step S18), the controller 14 determines that the voltage measurement equipment (the devices from the multiplexer 12 to the A/D converter 13) is operating in conformity and terminates the circuit diagnosis process. On the other hand, if the reference voltage is not conformity (NO in the step S18), the controller 14 determines that the voltage measurement equipment is nonconformity and outputs an alarm signal to the alarm unit (not illustrated) (step S19) to inform the operator of the nonconformity. The operator can therefore instantaneously recognize that the voltage measurement equipment is nonconformity.

As described above, in the battery pack voltage detection device according to the first embodiment, to measure the output voltages of the unit cells BT1 to BT4, all the switches of the first switch group 15 are turned on while the switches SW21 and SW22 are turned off for the voltage measurement process.

At the circuit diagnosis, by turning off all the switches of the first switch group 15 and turning on the switches SW21 and SW22, the desired reference voltages are applied to the connection lines L1 to L4 to supply the reference voltages to the terminals T1 to T4 of the multiplexer 12. The reference voltages are digitized by the A/D converter 13 and are then supplied to the controller 14. The controller 14 determines based on the voltages between each pair of the terminals T1 to T4 whether the voltage measurement equipment (the devices from the multiplexer 12 to the A/D converter 13) is operating in conformity. This makes it possible to recognize that any one of the multiplexer 12 and A/D converter 13 is nonconformity, thus implementing integrated nonconformity detection concerning the voltage measurement equipment.

Moreover, each of the series-connected circuits N1 to N4 includes the diodes D1 and D2. This can prevent current from flowing between the connection lines L1 to L4 when the first switch group 15 is on and the switches SW21 and SW22 are off.

Furthermore, the voltages generated at the respective points P1 to P4 can be arbitrarily set by determining the voltage dividing ratios by the resistors Ra1 to Ra4 and the resistors Rb1 to Rb4. This can increase the versatility in voltage setting. Moreover, the series-connected circuits N1 to N4 are connected to the same DC power supply VB to generate the reference voltages. Even when the output voltage of the DC power supply VB changes, therefore, the voltages generated at the points P1 to P4 relatively change. Accordingly, the process of diagnosing the voltage measurement equipment can be executed without being influenced by the changes in voltage as a whole.

If the diagnosis function according to the first embodiment is applied to unit cells of a lithium-ion battery mounted on a vehicle or the like, it is possible to quickly recognize that the voltage measurement equipment (the devices from the multiplexer 12 to the A/D converter 13) is failing. This can surely prevent overcharge and over discharge of the secondary battery.

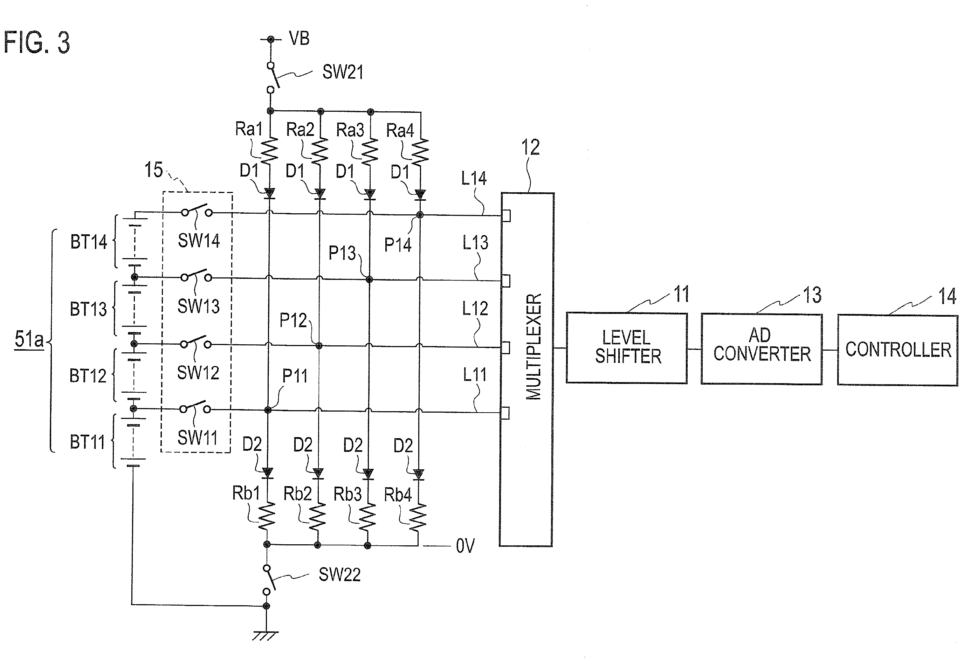

Next, a description is given of a modification of the first embodiment described above. Fig. 3 is a circuit diagram illustrating a configuration of a battery pack voltage detection device according to the modification of the first embodiment. As illustrated in Fig. 3, in the voltage detection device according to the modification, battery blocks BT11, Bt12, BT13, and BT14, each including a plurality of unit cells connected in series, are connected in series to constitute a battery pack 51a. The voltage detection device measures voltages of the respective battery blocks BT11 to BT14. Reference voltages are applied to points P11, P12, P13, and P14 on connection lines L11 to L14 which are connected to the positive electrodes of the voltage blocks BT11 to BT14, respectively, for the process of diagnosing voltage measurement equipment. The reference voltages are obtained by dividing the output voltage of the DC power supply Vb.

In the above described configuration, it is possible to diagnose whether the multiplexer 12 and the A/D converter 13 are operating in conformity. The numbers of unit cells provided for each of the battery blocks BT11 to BT14 illustrated in Fig. 3 may be the same or not.

Hereinabove, the battery pack voltage detection device of the present invention is described based on the embodiments illustrated in the drawings. However, the present invention is not limited to the embodiments, and the configuration of each part can be replaced with an arbitrary configuration having similar function. For example, in the description of the aforementioned embodiments, the secondary battery is mounted on an electric vehicle as the battery pack 51 or 51a. The present invention is not limited to this and can be applied to battery packs used in other than the electric vehicle.

### Industrial Applicability

The present invention is applicable to determination whether the output voltage of each unit cell provided for a battery pack is measured in conformity.

## Claims

1. A voltage detection device provided for a battery pack (51, 51a) which includes a series circuit having two or more battery blocks (BT1-BT4, BT11-BT14) connected in series and generates a desired voltage across both ends of the series circuit, the voltage detection device for detecting output voltage of each of the battery blocks (BT1-BT4, BT11-BT14), each of the battery blocks (BT1-BT4, BT11-BT14) including one or more unit cells (BT1-BT4), the voltage detection device comprising:
a voltage selector (12) which is connected to positive electrode terminals of the battery blocks (BT1-BT4, BT11-BT14) through connection lines (L1-L4, L11-L14) and selects output voltage of each of the battery blocks (BT1-BT4, BT11-BT14) based on the voltages generated at the positive electrode terminals;
the voltage detection device is **characterised by**:
first switches (15; SW11-SW14) provided between the positive electrode terminals and the connection lines (L1-L4, L11-L14), respectively;
an A/D converter (13) for digitizing a signal of the output voltage selected by the voltage selector (12);
a reference voltage output unit (N1-N4) capable of supplying different levels of reference voltages to the respective connection lines (L1-L4, L11-L14);
a second switch (SW21, SW22) for switching between supply and cutoff of the reference voltages outputted from the reference voltage output unit (N1-N4) to the respective connection lines (L1-L4, L11-L14);
a controller (14) performing a control to turn on the first switches (15; SW11-SW14) and turn off the second switch (SW21, SW22) in a process of detecting the output voltages of the battery blocks (BT1-BT4, BT11-BT14) and to turn off the first switches (15; SW11-SW14) and turn on the second switch (SW21, SW22) in a process of fault diagnosis for the voltage selector (12) and the A/D converter (13); and
a fault detector (14) which determines based on a voltage signal outputted from the A/D converter (13) whether at least one of the voltage selector (12) and A/D converter (13) is failing in the process of fault diagnosis.

2. The voltage detection device according to claim 1, wherein
the reference voltage output unit (N1-N4) includes series-connected circuits (N1-N4) each having two resistors (Ra1, Rb1, ...-Ra4, Rb4) corresponding to each of the connection lines (L1-L4, L11-L14),
an intermediate point between the two resistors (Ra1, Rb1, ...-Ra4, Rb4) of each of the series-connected circuits (N1-N4) is connected to concerned connection line (L1-L4, L11-L14),
one end of each of the series-connected circuits (N1-N4) is connected to a DC power supply (VB), and
voltage supplied to the concerned connection line (L1-L4, L11-L14) is set by setting proper resistive values of the two resistors (Ra1, Rb1, ...-Ra4, Rb4) of each of the series-connected circuits (N1-N4).

3. The voltage detection device according to claim 2, wherein
the series-connected circuits (N1-N4) are connected to a common DC power supply (VB).

4. The voltage detection device according to claim 1, wherein
each of the battery blocks (BT1-BT4) is composed of one unit cell (BT1-BT4).

5. The voltage detection device according to claim 1, wherein
the battery pack (51, 51a) is a secondary battery mounted on a vehicle.

## Patentansprüche

1. Spannungserkennungsvorrichtung, die für eine Batteriepackung (51, 51a) bereitgestellt ist, die eine Reihenschaltung, die zwei oder mehrere Batterieblöcke (BT1-BT4, BT11-BT14) aufweist, die in Reihe geschaltet sind, einschließt und eine gewünschte Spannung über beide Enden der Reihenschaltung erzeugt, wobei die Spannungserkennungsvorrichtung zum Erkennen von Ausgangsspannung jedes der Batterieblöcke (BT1-BT4, BT11-BT14) dient, wobei jeder der Batterieblöcke (BT1-BT4, BT11-BT14) eine oder mehrere Einheitszellen (BT1-BT4) einschließt, wobei die Spanungserkennungsvorrichtung umfasst:
einen Spannungswähler (12), der über Verbindungsleitungen (L1-L4, L11-L14) mit positiven Elektrodenanschlüssen der Batterieblöcke (BT1-BT4, BT11-BT14) verbunden ist und basierend auf den an den positiven Elektrodenanschlüssen erzeugten Spannungen Ausgangsspannung jedes der Batterieblöcke (BT1-BT4, BT11-BT14) auswählt;
wobei die Spannungserkennungsvorrichtung **gekennzeichnet ist durch**:
erste Schalter (15; SW11-SW14), die jeweils zwischen den positiven Elektrodenanschlüssen und den Verbindungsleitungen (L1-L4, L11-L14) bereitgestellt sind;
einen A/D-Wandler (13) zum Digitalisieren eines Signals der von dem Spannungswähler (12) ausgewählten Ausgangsspannung;
eine Referenzspannungsausgabeeinheit (N1-N4), die imstande ist, den jeweiligen Verbindungsleitungen (L1-L4, L11-L14) unterschiedliche Pegel von Referenzspannungen zuzuführen;
einen zweiten Schalter (SW21, SW22) zum Schalten zwischen Zuführen und Unterbrechen der Referenzspannungen, die von der Referenzspannungsausgabeeinheit (N1-N4) an die jeweiligen Verbindungsleitungen (L1-L4, L11-L14) ausgegeben werden;
eine Steuereinheit (14), die eine Steuerung durchführt, um in einem Prozess eines Erkennens der Ausgangsspannungen der Batterieblöcke (BT1-BT4, BT11-BT14) die ersten Schalter (15; SW11-SW14) anzuschalten und den zweiten Schalter (SW21, SW22) auszuschalten, und um in einem Prozess einer Fehlerdiagnose für den Spannungswähler (12) und den A/D-Wandler (13) die ersten Schalter (15; SW11-SW14) auszuschalten und den zweiten Schalter (SW21, SW22) anzuschalten; und
einen Fehlererkenner (14), der basierend auf einem von dem A/D-Wandler (13) ausgegebenen Spannungssignal bestimmt, ob mindestens einer von dem Spannungswähler (12) und dem A/D-Wandler (13) im Prozess der Fehlerdiagnose ausfällt.

2. Spannungserkennungsvorrichtung nach Anspruch 1, wobei
die Referenzspannungsausgabeeinheit (N1-N4) in Reihe geschaltete Schaltungen (N1-N4) einschließt, die jeweils zwei Widerstände (Ra1, Rb1, ...-Ra4, Rb4) aufweisen, die jeder der Verbindungsleitungen (L1-L4, L11-L14) entsprechen,
ein Zwischenpunkt zwischen den zwei Widerständen (Ra1, Rb1, ...-Ra4, Rb4) jeder der in Reihe geschalteten Schaltungen (N1-N4) mit betreffender Verbindungsleitung (L1-L4, L11-L14) verbunden ist,
ein Ende jeder der in Reihe geschalteten Schaltungen (N1-N4) mit einer Gleichstromzufuhr (VB) verbunden ist, und
Spannung, die der betreffenden Verbindungsleitung (L1-L4, L11-L14) zugeführt wird, durch Einstellen passender Widerstandswerte der zwei Widerstände (Ra1, Rb1, ...-Ra4, Rb4) jeder der in Reihe geschalteten Schaltungen (N1-N4) eingestellt wird.

3. Spannungserkennungsvorrichtung nach Anspruch 2, wobei
die in Reihe geschalteten Schaltungen (N1-N4) mit einer gemeinsamen Gleichstromzufuhr (VB) verbunden sind.

4. Spannungserkennungsvorrichtung nach Anspruch 1, wobei
jeder der Batterieblöcke (BT1-BT4) aus einer Einheitszelle (BT1-BT4) zusammengesetzt ist.

5. Spannungserkennungsvorrichtung nach Anspruch 1, wobei
die Batteriepackung (51, 51a) eine auf einem Fahrzeug montierte Sekundärbatterie ist.

## Revendications

1. Dispositif de détection de tension fourni pour un bloc-pile (51, 51a) qui inclut un circuit en série présentant deux blocs-pile (BT1-BT4, BT11-BT14) ou plus connecté en série et génère une tension souhaitée entre les deux extrémités du circuit en série, le dispositif de détection de tension conçu pour détecter une tension de sortie de chacun des blocs-pile (BT1-BT4, BT11-BT14), chacun des blocs-pile (BT1-BT4, BT11-BT14) incluant un ou plusieurs éléments unitaires (BT1-BT4), le dispositif de détection de tension comprenant :
un sélecteur de tension (12) qui est connecté à des bornes d'électrodes positives des blocs-pile (BT1-BT4, BT11-BT14) par l'intermédiaire de lignes de connexion (L1-L4, L11-L14) et sélectionne la tension de sortie de chacun des blocs-pile (BT1-BT4, BT11-BT14) sur la base des tensions générées au niveau des bornes d'électrodes positives ;
le dispositif de détection de tension est **caractérisé par** :
de premiers commutateurs (15 ; SW11-SW14) fournis entre les bornes d'électrodes positives et les lignes de connexion (L1-L4, L11-L14), respectivement ;
un convertisseur A/N (13) pour numériser un signal de la tension de sortie sélectionnée par le sélecteur de tension (12) ;
une unité de production de tension de référence (N1-N4) capable de fournir différents niveaux de tensions de référence aux lignes de connexion (L1-L4, L11-L14) respectives ;
un second commutateur (SW21, SW22) pour commuter entre la fourniture et la coupure des tensions de référence produites par l'unité de production de tension de référence (N1-N4) et envoyées aux lignes de connexion (L1-L4, L11-L14) respectives ;
un dispositif de contrôle (14) réalisant un contrôle pour mettre sous tension les premiers commutateurs (15 ; SW11-SW14) et mettre hors tension le second commutateur (SW21, SW22) dans un processus de détection des tensions de sortie des blocs-pile (BT1-BT4, BT11-BT14) et pour mettre hors tension les premiers commutateurs (15 ; SW11-SW14) et mettre sous tension le second commutateur (SW21, SW22) dans un processus de diagnostic de panne pour le sélecteur de tension (12) et le convertisseur A/N (13) ; et
un détecteur de panne (14) qui détermine sur la base d'un signal de tension produit par le convertisseur A/N (13) si au moins un du sélecteur de tension (12) et du convertisseur A/N (13) est en échec dans le processus de diagnostic de panne.

2. Dispositif de détection de tension selon la revendication 1, dans lequel
l'unité de production de tension de référence (N1-N4) inclut des circuits (N1-N4) connectés en série présentant chacun deux résistances (Ra1, Rb1, ... -Ra4, Rb4) correspondant à chacune des lignes de connexion (L1-L4, L11-L14),
un point intermédiaire entre les deux résistances (Ra1, Rb1, ... -Ra4, Rb4) de chacun des circuits (N1-N4) connectés en série est connecté à la ligne de connexion (L1-L4, L11-L14) concernée,
une extrémité de chacun des circuits (N1-N4) connectés en série est connectée à une alimentation en CC (VB), et
la tension fournie à la ligne de connexion (L1-L4, L11-L14) concernée est réglée en réglant des valeurs de résistance correctes des deux résistances (Ra1, Rb1, ... -Ra4, Rb4) de chacun des circuits (N1-N4) connectés en série.

3. Dispositif de détection de tension selon la revendication 2, dans lequel
les circuits (N1-N4) connectés en série sont connectés à une alimentation en CC (VB) commune.

4. Dispositif de détection de tension selon la revendication 1, dans lequel
chacun des blocs-pile (BT1-BT4) est composé d'un élément unitaire (BT1-BT4).

5. Dispositif de détection de tension selon la revendication 1, dans lequel
le bloc-pile (51, 51a) est une pile secondaire montée sur un véhicule.
